# FASCICULE DE BREVET EUROPEEN

(11) **EP 2 764 535 B1**
(45) Date de publication et mention de la délivrance du brevet: **14.10.2015**
(21) Numéro de dépôt: 12773069.5
(22) Date de dépôt: 20.09.2012
(51) Int. Cl.: H01L 21/18, H01L 21/20

(54) **PROCÉDÉ DE DOUBLE REPORT DE COUCHE**
Verfahren zum doppelten Übertragen einer Schicht
DOUBLE LAYER TRANSFER METHOD

(30) Priorité: 04.10.2011 FR 1158944
(43) Date de publication de la demande: 13.08.2014
(73) Titulaire: Commissariat à l'Énergie Atomique et aux Énergies Alternatives, 75015 Paris (FR)
(72) Inventeur: FOURNEL, Frank, F-38190 Villard-Bonnot (FR); ARGOUD, Maxime, F-38110 LA CHAPELLE DE LA TOUR (FR); DA FONSECA, Jérémy, F-38470 Teche (FR); MORICEAU, Hubert, F-38120 Saint-Egreve (FR)
(74) Mandataire: Delorme, Nicolas
(86) Numéro de dépôt international: PCT/FR2012/052100
(87) Numéro de publication internationale: WO 2013/050683

(56) Documents cités:
- FR-A1- 2 849 268
- JP-A- 2010 054 695
- US-A1- 2003 108 715
- US-A1- 2006 240 275
- US-A1- 2009 156 016
- ROELKENS G ET AL: "Heterogeneous Integration of III-V Active Devices on a Silicon-on-Insulator Photonic Platform", 4TH IEEE INTERNATIONAL CONFERENCE ON GROUP IV PHOTONICS - 19-21 SEPT. 2007 - TOKYO, JAPAN, IEEE, US, 19 septembre 2007 (2007-09-19), pages 1-3, XP032144776, DOI: 10.1109/GROUP4.2007.4347659 ISBN: 978-1-4244-0934-1
- ROELKENS ET AL: "III-V/Si photonics by die-to-wafer bonding", MATERIALS TODAY, ELSEVIER SCIENCE, KIDLINGTON, GB, vol. 10, no. 7-8, 1 juillet 2007 (2007-07-01), pages 36-43, XP022119453, ISSN: 1369-7021, DOI: 10.1016/S1369-7021(07)70178-5
- BROUCKAERT J ET AL: "Compact InAlAs-InGaAs Metal- Semiconductor- Metal Photodetectors Integrated on Silicon-on-Insulator Waveguides", IEEE PHOTONICS TECHNOLOGY LETTERS, IEEE SERVICE CENTER, PISCATAWAY, NJ, US, vol. 19, no. 19, 1 octobre 2007 (2007-10-01), pages 1484-1486, XP011191686, ISSN: 1041-1135, DOI: 10.1109/LPT.2007.903767

## Description

La présente invention concerne un procédé de transfert de couche notamment composée d'un matériau semi-conducteur, isolant ou métallique. L'invention concerne également une structure intermédiaire et une structure finale comprenant une couche reportée, par exemple, par le procédé de transfert de couche. Ce procédé et ces structures peuvent notamment trouver une application dans le domaine des technologies souples, de l'électronique, par exemple de l'électronique flexible comme les cartes à puce, les textiles intelligents, des MEMS (microsystème électromécanique), des NEMS (nanosystème électromécanique), de l'électronique de forte puissance, RF et micro-onde, la microélectronique, l'optique, l'optoélectronique et le photovoltaïque.

Pour l'élaboration de substrats innovants, il est très souvent intéressant de pouvoir transférer une couche d'un substrat initial sur un substrat intermédiaire afin de réaliser des étapes technologiques incompatibles avec le substrat initial. De plus, le transfert sur un substrat intermédiaire permet d'accéder à une face arrière de la couche qui n'est pas exposée lorsque la couche est collée sur un substrat initial. Ensuite, il est souvent nécessaire de procéder à un deuxième transfert de ladite couche depuis le substrat intermédiaire sur un substrat final adapté à l'application finale. Afin de minimiser les coûts de production, ces transferts doivent être réalisés sans perte des substrats initiaux et intermédiaires afin de pouvoir réutiliser ces derniers. Pour cela, il faut réussir à transférer par décollement, la couche d'un substrat à un autre. Cependant, pour réaliser deux transferts de ce type, les énergies de collage doivent être judicieusement choisies. En effet, le transfert du substrat initial au substrat intermédiaire demande que l'énergie de collage de la couche sur le support intermédiaire, Ei, soit supérieure à l'énergie de collage de la couche sur son support initial, E0. De même, le deuxième transfert demande que l'énergie du collage final entre la couche et le substrat final, Ef, soit plus forte que l'énergie de collage entre la couche et le substrat intermédiaire, Ei. Ces conditions peuvent être présentées sous la forme des inégalités E0 < Ei < Ef.

Or, l'ordre des énergies de liaison de ces différents collages restreint fortement le nombre de technologies possibles pour mettre en oeuvre le collage de la couche sur les différents substrats et le décollement sélectif de la couche de ces mêmes substrats. Notamment, il semble impossible d'utiliser le même procédé pour le collage de la couche sur le substrat initial (première étape) et pour le collage de la couche et du substrat final (dernière étape). En effet, si le même procédé ou type de collage est mis en oeuvre aux première et dernière étapes, ce que l'on peut assimiler à des collages présentant une énergie de collage similaire, il ne semble pas possible de trouver un collage intermédiaire possédant une énergie de liaison plus forte que le premier collage et en même temps plus faible que le dernier collage.

US2003/0108715 divulgue un procédé d'un double transfert d'une couche sur un substrat intermédiaire et ensuite sur un substrat finals US2006/0240275 divulgue une structure intermédiaire et final avec un substrat final en polymère et une couche en silicium.

Un des buts de l'invention est de pallier à cet inconvénient, tout en garantissant une méthode économique et permettant de mettre en oeuvre des étapes technologiques sur la face arrière de la couche.

A cet effet, et selon un premier aspect, l'invention a pour objet un procédé de transfert d'une couche, notamment composée d'un matériau semi-conducteur, isolant ou métallique, le procédé comprenant les étapes de :
a) fourniture d'une couche solidaire d'un substrat initial avec une énergie de liaison E0 entre la couche et le substrat initial;
b) collage d'une face avant de la couche sur un substrat intermédiaire selon une énergie de collage intermédiaire Ei;
c) détachement du substrat initial de la couche pour exposer la face arrière de la couche;
e) collage d'une face arrière sur un substrat final selon une énergie de collage final Ef; et
f) décollement du substrat intermédiaire de la couche pour transférer la couche sur le substrat final;
l'étape b) comprenant une étape de formation de liaisons siloxanes Si-O-Si, l'étape c) étant réalisée sous une première atmosphère anhydre et l'étape f) étant réalisée sous une deuxième atmosphère humide de sorte que l'énergie de collage intermédiaire Ei prend une première valeur Ei1 à l'étape c) et une deuxième valeur Ei2 à l'étape f), avec Ei1 > EO et Ei2 < Ef, et avec Ei1 > Ei2..

Dans la présente demande, par le terme 'couche', on entend une couche à transférer qui peut présenter des épaisseurs diverses. Il peut s'agir d'une couche mince, dont l'épaisseur est telle que la couche est très souple. La couche mince est de ce fait difficilement manipulée et s'enroule facilement sur elle-même. Le procédé selon l'invention est avantageusement appliqué à ce type de couche car à chaque étape, la couche mince est solidaire d'un substrat raidisseur ou support, qui lui confère une rigidité mécanique. Il est ainsi possible de procéder à des étapes technologiques, notamment des gravures ou des dépôts de matériaux sur la couche solidarisée à un substrat. L'épaisseur d'une couche mince est déterminée par les propriétés physiques intrinsèques du matériau considéré. L'épaisseur d'une couche mince silicium peut être comprise entre quelques dizaines de nanomètres et environ 150 micromètres par exemple.

La couche à transférer peut également consister en une couche autoportée, à savoir une couche dont l'épaisseur est telle que la couche possède la rigidité suffisante pour être facilement manipulée. La couche peut aussi comprendre un substrat ou une plaquette d'une épaisseur de plusieurs centaines de micromètres.

Par convention, on désigne par la 'face avant' de la couche, la face libre ou exposée de la couche lorsqu'elle est solidaire du substrat initial. Réciproquement, la 'face arrière' est la face de la couche qui est opposée à la face avant.

Par ailleurs, l'énergie de liaison de l'étape a) du procédé peut comprendre une énergie de collage ou une énergie de tenue de la couche sur le substrat initial.

Ainsi, le procédé selon l'invention met en oeuvre un double report de couche de sorte que des étapes technologiques peuvent être exécutées sur la face arrière exposée ou libre de la couche lorsque la face avant est collée à un substrat intermédiaire. De plus, lors du double report de couche, il est fréquent de mettre en oeuvre des étapes de gravure du substrat que l'on souhaite retirer, ce qui conduit à la perte du substrat. Le procédé selon l'invention permet avantageusement de détacher ou de décoller sélectivement les substrats que l'on souhaite retirer de sorte qu'il est possible de les recycler pour les réutiliser dans le procédé.

Les liaisons siloxanes Si-O-Si mises en oeuvre à l'étape b) du procédé selon l'invention sont des liaisons covalentes. Ces liaisons Si-O-Si assurent ainsi une forte énergie de collage intermédiaire Ei entre la couche et le substrat intermédiaire. De plus, ces liaisons siloxanes Si-O-Si sont sensibles à la présence d'humidité. Il est alors possible de moduler l'énergie de collage Ei en modifiant la teneur en eau du milieu dans lequel ces liaisons siloxanes sont placées. Ainsi, lorsque la première atmosphère de l'étape c) selon l'invention est anhydre, les liaisons siloxanes procurent une énergie de collage Ei1 plus importante que celle Ei2 obtenue au sein de la deuxième atmosphère humide de l'étape f) selon l'invention.

Par ailleurs, cette méthode permet de se soustraire des exigences des procédés de double report de couche connus. Dans ces procédés, il est en effet nécessaire que l'énergie de collage E0 soit inférieure à la valeur de l'énergie Ef de sorte que l'énergie de collage intermédiaire Ei soit comprise entre les énergies E0 et Ef. Ceci implique que les types de collage entre la couche et le substrat initial et entre la couche et le substrat final soient différents. Or, le procédé de la présente invention permet avantageusement un collage intermédiaire d'une énergie Ei variable, de sorte qu'Ei puisse être supérieure à E0 lors du détachement du substrat initial, et puisse également être inférieure à Ef lors du décollement du substrat intermédiaire. Il est alors possible d'appliquer un type de collage identique de la couche sur le substrat initial et sur le substrat final et d'employer une énergie E0 similaire à l'énergie Ef.

Il va sans dire que le procédé selon l'invention permet également d'utiliser un collage entre la couche et le substrat initial qui est différent du collage entre la couche et le substrat final. Il est ainsi possible selon le procédé de l'invention que l'énergie de collage E0 soit différente de l'énergie de collage Ef et que l'énergie Ei2 soit supérieure ou égale à Ei1.

Selon un mode de mise en oeuvre, l'étape b) du procédé comprend une étape de mise en oeuvre d'un collage direct hydrophile. Par 'collage direct' de la couche avec le substrat intermédiaire, on entend que le collage est basé sur une adhésion moléculaire des surfaces mises en contact direct, c'est-à-dire sans ajouter de colle à l'interface, ni adhésif, cire, ou métal à basse température de fusion. Dans ce cas, les forces attractives entre les deux surfaces, notamment les forces de Van der Waals, sont suffisamment élevées pour provoquer l'adhérence moléculaire. Aussi, ce collage moléculaire direct est 'hydrophile' en ce qu'il comprend la mise en contact de deux surfaces hydrophiles avec une capacité d'accueil de molécules d'eau. Ce collage met alors en jeu des interactions par formation de liaisons hydrogènes entre les deux surfaces. Ces liaisons procurent une des interactions les plus fortes des liaisons de Van der Waals. Ce mode de collage direct hydrophile assure ainsi une forte énergie de collage entre la couche et le substrat intermédiaire à température ambiante.

De préférence, le collage direct hydrophile de l'étape b) est suivi d'une étape de recuit de stabilisation de collage. Ce recuit consiste en l'application d'un traitement thermique pendant quelques minutes à quelques heures de sorte à favoriser la formation des liaisons hydrogènes et des liaisons covalentes entre les deux surfaces. De ce fait, un collage intime présentant une énergie de collage plus importante que celle procurée par la simple mise en contact direct des surfaces hydrophiles est obtenu.

Selon une alternative, l'étape b) du procédé comprend une étape de mise en oeuvre d'un collage anodique. Par 'collage anodique' on entend un collage direct, tel que décrit précédemment, comprenant la mise en contact d'une couche de silicium et d'une couche d'oxyde de silicium ou de deux couches d'oxyde de silicium, un traitement thermique à haute température, et une différence de potentiel élevée entre les couches et/ou substrats à coller. La température du traitement thermique se situe typiquement autour de 400°C et la différence de potentiel appliquée est typiquement de l'ordre de plusieurs centaines de volts.

Selon un mode de réalisation, le procédé comprend, avant l'étape b), une étape de polissage mécano-chimique et/ou d'une étape nettoyage de la face avant de la couche et de la surface du substrat intermédiaire. Le polissage mécano-chimique, également connu de l'homme du métier sous la dénomination CMP (abréviation anglo-saxonne de Chemical Mechanical Polishing) a pour effet réduire la rugosité des surfaces à coller de sorte à améliorer le rapprochement des surfaces afin d'augmenter les interactions et initier la formation des liaisons. Le polissage est appliqué jusqu'à obtenir une rugosité inférieure à environ 5 angström RMS (abréviation anglo-saxonne de Root Mean Square) sur un champ de 5 micromètres x 5 micromètres. Par ailleurs, le nettoyage a pour effet de retirer les particules isolées sur les surfaces, qui peuvent porter préjudice à un bon collage. Le nettoyage permet également de rendre les surfaces hydrophiles avant leur mise en contact. Ces étapes permettent ainsi de réaliser un bon collage hydrophile direct.

Selon un mode de mise en oeuvre, le procédé comprend une étape de formation d'une couche de silicium ou d'une couche d'oxyde choisi parmi le SiO2 natif, le SiO2 thermique, le SiO2 déposé, le SiOx et le SixOyNz, respectivement sur la face avant de la couche et sur le substrat intermédiaire. L'étape b) du procédé comprend également une étape de mise en contact des couches formées de sorte à obtenir la formation de liaisons siloxanes Si-O-Si. La valeur x de l'oxyde de silicium non stoechiométrique SiOx est différente de zéro. De même, les valeurs de x, y et de z de l'oxynitrure de silicium SixOyNz sont différentes de zéro. La couche de silicium s'oxydera à l'air pour former une couche d'un oxyde natif de sorte à rendre possible la formation des liaisons Si-O-Si. Ces couches permettent ainsi de former les liaisons covalentes entre la couche et le substrat intermédiaire et d'obtenir une forte énergie de collage intermédiaire Ei.

L'oxyde natif est un oxyde qui se forme naturellement en présence d'air à la surface d'un matériau de silicium. L'épaisseur d'une telle couche d'oxyde est naturellement limitée à environ 10 - 15 angströms. L'oxyde de silicium thermique peut être obtenu par oxydation thermique de silicium sous atmosphère humide. L'oxyde peut également être élaboré par chimie sèche ou humide. L'oxyde SiO2 déposé, l'oxyde SiOx et l'oxynitrure SiOxNy sont couramment obtenus par dépôt selon diverses techniques connues telles que par CVD, (abréviation anglo-saxonne de Chemical Vapor Déposition), et par PVD (abréviation anglo-saxonne de Physical Vapor Déposition) etc...L'oxyde peut également être élaboré avec une technologie plasma telle que la gravure RIE (abréviation anglo-saxonne de Reative Ion Etch), l'ICP (abréviation anglo-saxonne de Inductive Coupled Plasma) ou l'ECR (abréviation anglo-saxonne de Electron Cyclotron Resonance). Ces technologies d'élaboration de l'oxyde peuvent être utilisées seules ou en combinaison. Il est par ailleurs entendu que l'oxyde peut comporter des éléments dopants sans sortir du cadre de l'invention. Dans la présente demande, un traitement thermique peut être appliqué aux oxydes déposés afin de les densifier et de modifier leurs propriétés de collage.

Selon un aspect de l'invention, la première atmosphère anhydre du procédé, présente une teneur en vapeur d'eau inférieure à 1 ppm. Dans la présente demande, l'expression 'atmosphère anhydre' définit une atmosphère comprenant moins d'humidité qu'une atmosphère définie par l'expression 'atmosphère humide' utilisée ci-dessous. Cette atmosphère anhydre est bénéfique au détachement entre la couche et le substrat initial. L'absence d'humidité permet en effet de procurer une forte énergie de collage Ei1 entre la couche et le substrat intermédiaire de sorte que l'énergie Ei1 est supérieure à l'énergie de liaison E0 entre la couche et le substrat initial.

Préférentiellement, l'atmosphère anhydre est une atmosphère d'azote sec. L'utilisation de cette atmosphère est avantageuse en ce qu'elle est simple à mettre en place et offre une ambiance neutre pour les matériaux utilisés.

Selon un autre aspect de l'invention, la deuxième atmosphère humide du procédé, présente une teneur en humidité comprise entre 20% et 80%. La présence d'humidité favorise en effet un affaiblissement proportionnel de l'énergie de collage entre la couche mince et le substrat intermédiaire. Il est alors possible de faire varier la valeur de l'énergie Ei2 par le choix d'un taux d'humidité approprié.

De préférence, la deuxième atmosphère comprend un taux d'humidité d'environ 40%. En effet, l'atmosphère des salles blanches présente typiquement un taux d'humidité de 40%. Il n'est donc pas nécessaire de prévoir une enceinte spécifique, dont le taux d'humidité de l'atmosphère serait réglée différemment de celui de la salle blanche, afin d'effectuer le décollement.

De façon avantageuse, le détachement de l'étape c) et/ou le décollement de l'étape f) comprend l'application concomitante d'une contrainte mécanique, telle que l'utilisation de mâchoires, l'application d'une lame ou d'un coin respectivement entre la couche et le substrat initial, et entre le substrat intermédiaire et la couche. La contrainte mécanique permet en effet d'affaiblir l'énergie de liaison E0 à l'étape c) et l'énergie de collage Ei2 à l'étape f). Les mâchoires permettent notamment de séparer la couche des substrats au niveau de l'interface la plus faible par un mécanisme d'aspiration.

Selon une variante, le détachement de l'étape c) comprend l'application d'un jet pressurisé d'air sec ou d'azote, ou d'une irradiation laser.

Selon une autre variante, le décollement de l'étape f) est obtenu par jets pressurisés d'air humide ou d'eau.

Une autre caractéristique optionnelle de ce procédé consiste en une étape technologique d), qui est réalisée entre les étapes c) et e), et qui est appliquée à la face arrière de la couche, le budget thermique de l'étape technologique présentant une valeur inférieure à une valeur seuil au-delà de laquelle Ei2 > Ef. Par l'expression budget thermique, on entend l'application d'un traitement thermique sur une période de temps donnée. En effet, l'application d'un budget thermique peut initier la formation de nouvelles liaisons siloxanes qui renforcent encore l'énergie de collage intermédiaire Ei2 entre la couche et le substrat intermédiaire. Le contrôle du budget thermique garantit ainsi que l'énergie de collage intermédiaire Ei2 reste inférieure à l'énergie de collage final Ef. Cette étape technologique d) permet ainsi de fonctionnaliser la face arrière de la couche mécaniquement rigidifiée par le collage avec le substrat intermédiaire tout en limitant l'énergie du collage intermédiaire Ei2 pour le report de la couche sur le substrat final.

Selon un mode de mise en oeuvre, l'étape technologique d) comprend la gravure ionique et/ou la gravure chimique et/ou la photolithographie et/ou le dépôt d'au moins une couche de matériau, notamment choisi parmi les matériaux semi-conducteurs. Le dépôt de couche peut être réalisé par épitaxie et peut comprendre la formation d'une ou plusieurs couches tampons pour ajuster le paramètre de maille du matériau de la couche servant alors de germe à celui du matériau de la couche épitaxiée.

De préférence, l'étape e) du procédé comprend une étape de collage mise en oeuvre par l'intermédiaire d'un film adhésif, tel qu'un film de DiVinylSiloxane-bis-BenzoCycloButène (DVS-bis-BCB), de polyimide ou de polymère photosensible. L'utilisation d'un film adhésif permet d'obtenir un collage simple à mettre en oeuvre notamment en ce qu'il n'est pas nécessaire de planariser et de nettoyer les surfaces avec beaucoup de précision.

Selon une variante, l'étape e) du procédé comprend une étape de collage par adhésion moléculaire telle que l'énergie de collage final possède une valeur Ef indépendante du taux d'humidité de la deuxième atmosphère. Ce collage peut notamment être mis en oeuvre par le dépôt d'une couche de nitrure de silicium SixNy ou SiNx :H sur la face arrière de la couche et/où sur le substrat final. Les valeurs de x et y sont respectivement différentes de la valeur zéro, le nitrure pouvant être du Si3N4 par exemple. Ce collage peut également être mis en oeuvre pas un collage direct hydrophobe. Le collage par adhésion moléculaire est avantageux en ce qu'il peut conduire à une grande énergie de collage.

Selon un autre mode de réalisation, l'énergie de liaison E0 entre la couche et le substrat initial est obtenue par formation d'une couche poreuse sur laquelle la couche est déposée. La couche poreuse est obtenue par exemple par le procédé Eltran dont on pourra trouver un exemple de description dans T. Yonehara, K. Sakagushi and N. Sato, Appl. Phys. Lett.. vol. 64 (16), pp.2108-2110 (1994). La couche poreuse est avantageuse en ce qu'elle présente une faible énergie de tenue E0, ce qui favorise la rupture de la liaison entre la couche et le substrat initial lors de l'étape c) du procédé. Par ailleurs, le fait de déposer la couche sur la face supérieure de la couche poreuse permet d'accéder à des couches d'épaisseurs importantes, difficilement atteintes par d'autres méthodes d'obtention. La couche est préférentiellement déposée par épitaxie sur la couche poreuse afin de former une couche monocristalline.

Selon encore un autre mode de réalisation, la couche est obtenue par implantation d'espèces ioniques à travers la face avant d'un substrat de sorte à obtenir un plan de fragilisation de part et d'autre de la couche et d'un substrat initial. L'énergie de liaison E0 entre la couche et le substrat initial au niveau du plan de fragilisation est suffisamment faible pour faciliter le transfert de la couche sur le substrat intermédiaire. A cet effet, on peut employer la technique Smart Cut^{™}, dont on pourra par exemple trouver une description dans Silicon-On- Insulator Technology : Materials to VLSI, 2nd Edition de Jean-Pierre Colinge (Kluwer Academic Publishers, p.50 et 51).

Dans les deux modes de réalisation de l'étape a) du procédé selon l'invention précédemment décrits et lorsque l'étape l'étape e) du procédé selon l'invention comprend une étape de collage par adhésion moléculaire, il est entendu que l'énergie de liaison E0 est inférieure à l'énergie de collage Ef. Il est alors possible que l'énergie Ei2 soit supérieure à l'énergie Ei1.

De préférence, la couche comprend un matériau de silicium monocristallin et le substrat intermédiaire comprend un matériau de silicium. Le matériau du substrat intermédiaire en silicium monocristallin ou polycristallin permet d'assurer une grande résistance à la température et à des environnements corrosifs afin de rendre possible l'application de nombreux types d'étapes technologiques sur la couche.

En variante, la couche comprend un matériau choisi parmi un matériau composé de silicium et de germanium, un matériau d'éléments du groupe II-VI et un matériau binaire, ternaire ou quaternaire d'éléments du groupe III-V. Les matériaux III-V sont notamment avantageux pour des applications dans le domaine photovoltaïque et optoélectronique, notamment pour fabriquer des lasers et des diodes. Par ailleurs, lorsque le matériau constitutif possède une structure cristalline polaire, comme cela peut être le cas pour les matériaux comportant des éléments III-N tel que le GaN, la couche peut alors présenter deux faces de polarité différentes qui conduit à des propriétés différentes. Il est alors particulièrement intéressant de pouvoir accéder et fonctionnaliser la face arrière de la couche qui présente des propriétés différentes de la face avant.

Le matériau du substrat initial et le matériau du substrat final comprennent un matériau choisi parmi le saphir, le silicium, le germanium, la silice, un verre, un quartz, un matériau d'éléments du groupe II-VI, un matériau binaire, ternaire ou quaternaire d'éléments du groupe III-V tel que l'AsGa, l'InP ou le GaN, un métal, un alliage métallique et un polymère, par exemple un polyimide tel que le Kapton®. Un matériau choisit parmi les polymères présentent l'avantage d'être facilement collé par l'intermédiaire d'un film adhésif. Le polymère peut être également décollé de la couche mince par des techniques plus nombreuses, notamment par l'application d'une contrainte mécanique associée à une contrainte d'arrachement. De plus, la souplesse des substrats de polymères peut être judicieusement utilisée pour des applications dans les domaines des technologies souples, de l'électronique flexible comme les cartes à puce, des textiles intelligents et notamment pour la fabrication de jauges de contrainte.

Selon un deuxième aspect, l'invention concerne une structure intermédiaire formée d'un empilement comprenant
- un substrat final en polymère,
- un film adhésif à base de DiVinylSiloxane-bis-BenzoCycloButène (DVS-bis-BCB),
- une couche en silicium monocristallin, et
- un substrat intermédiaire de silicium collé à une face avant de la couche par des liaisons siloxanes Si-O-Si.

Une telle structure permet ainsi de faciliter le décollement de la couche du substrat intermédiaire pour un report sur un substrat final, en faisant varier le taux d'humidité présent dans l'atmosphère.

En particulier, l'énergie de collage final Ef entre une face arrière de la couche et le substrat final de la structure intermédiaire est supérieure à l'énergie de collage intermédiaire Ei2 entre la face avant de la couche et le substrat intermédiaire sous une atmosphère présentant une teneur en humidité comprise entre 20 et 80%. Dans ces conditions, il est alors possible de détacher la couche du substrat intermédiaire.

Avantageusement, la face arrière de la couche présente des fonctionnalités en vue d'applications dans le domaine des technologies souples, de l'électronique flexible.

Selon un troisième aspect, l'invention concerne une structure finale, comprenant un
- substrat final en polymère,
- un film adhésif à base de DVS-bis-BCB, et
- une couche en silicium monocristallin,
la face arrière de la couche présentant des fonctionnalités en vue d'applications dans le domaine des technologies souples, de l'électronique flexible telle que les cartes à puce, les textiles intelligents, de l'électronique, des MEMS, des NEMS, de l'électronique de forte puissance, RF et micro-onde, la microélectronique, l'optique, l'optoélectronique et le photovoltaïque.

La couche ainsi fonctionnalisée peut servir de couche active dans un dispositif des domaines précités. De plus, la face avant de la couche étant libre et exposée, il est également possible de mettre en oeuvre des étapes technologiques sur cette surface.

D'autres aspects, buts et avantages de la présente invention apparaîtront mieux à la lecture de la description suivante de deux modes de réalisation de celle-ci, donnée à titre d'exemples non limitatifs et faite en référence aux dessins annexés. Les figures ne respectent pas nécessairement l'échelle de tous les éléments représentés de sorte à améliorer leur lisibilité. Des traits pointillés sont utilisés sur les figures de sorte à illustrer distinctement et clairement une couche de matériau qui, malgré les pointillés, se présente sous une forme continue. Dans la suite de la description, par souci de simplification, des éléments identiques, similaires ou équivalents des différentes formes de réalisation portent les mêmes références numériques.
Les figures 1A à 1J représentent des étapes d'un procédé de transfert d'une couche selon un premier mode de réalisation de l'invention.
La figure 2 est un graphe illustrant la variation de l'énergie de collage intermédiaire Ei, sous atmosphère anhydre et sous atmosphère humide, en fonction de la température.
Les figures 3A et 3E représentent des étapes d'un procédé de transfert d'une couche de matériau selon un deuxième mode de réalisation l'invention.

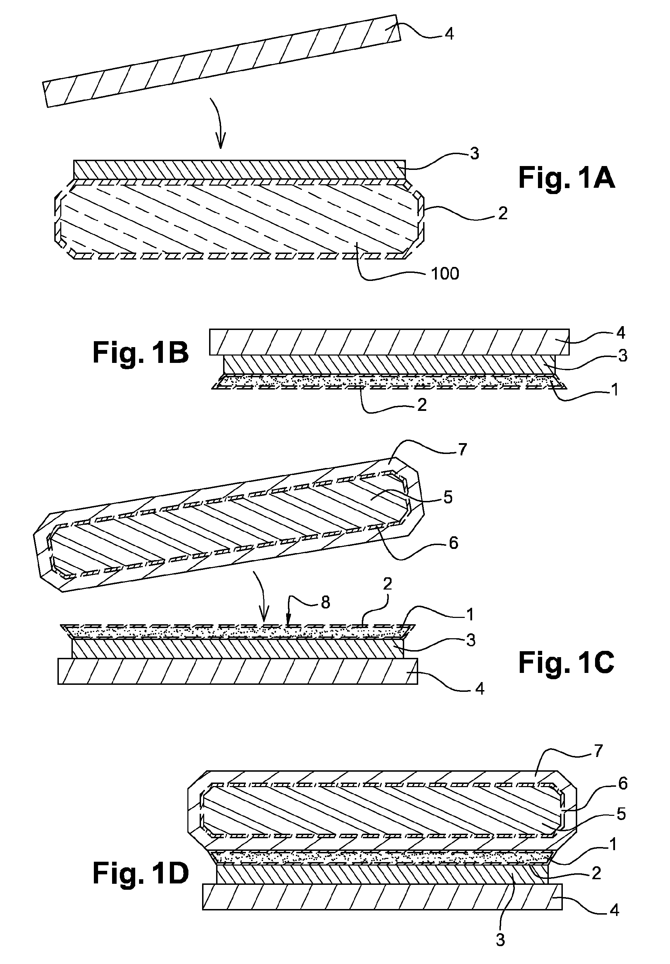

En référence à la figure 1A, le procédé est mis en oeuvre à partir d'un substrat donneur 100 de silicium d'une épaisseur d'environ 725 micromètres à partir duquel la couche 1 à transférer sera préparée. Une tel substrat 100 présente typiquement des tombées de bord à la périphérie de sa surface qui sont pratiquées selon les normes SEMI. Ces tombées de bord facilitent la manipulation du substrat qui pourrait sinon s'écailler et créer des particules en surface, susceptibles de gêner un collage ultérieur. Une couche d'oxyde natif 2 est formée en surface du substrat 100 au contact de l'air. Un film adhésif 3 en polymère de DVS-bis-BCB est déposé sur le substrat 100 de silicium, avec une épaisseur de 10 micromètres par enduction centrifuge ou dépôt à la tournette, méthode bien connue de l'homme de l'art sous la dénomination anglaise 'spin coating'. Le film 3 de DVS-bis-BCB est ensuite réticulé par application d'un traitement thermique à 250°C sur 1 heure. Un substrat 4 de polymère, par exemple un polyimide tel que le "Kapton®", présentant une épaisseur supérieure à 50 micromètres, est ensuite collé par thermo-compression à une température de 250°C sur le substrat donneur 100 de silicium par l'intermédiaire du film 3 de DVS-bis-BCB réticulé.

En référence à la figure 1B, on amincit ensuite le substrat 100 de silicium jusqu'à l'obtention d'une couche 1 à transférer d'une épaisseur d'environ 50 micromètres, par exemple par rodage, amincissement chimique et par un polissage mécano-chimique CMP. Le collage de la couche 1 de silicium collée avec le substrat initial 4 de polyimide possède une énergie moyenne de liaison E0 d'environ 2J/m². Une couche d'oxyde natif 2 est naturellement formée à la surface de la couche 1 de silicium au contact de l'air.

En référence à la figure 1C, un substrat intermédiaire 5 de silicium recouvert d'une couche d'oxyde natif 6 et d'une couche d'oxyde de silicium 7 déposé est collé par collage direct hydrophile sur la face avant 8 de la couche 1 de silicium. Au préalable, la face avant 8 de la couche 1 de silicium et le substrat intermédiaire 5 ont été préparés pour le collage. La couche 1 de silicium est planarisée par un polissage mécano-chimique de sorte d'atteindre une rugosité de surface inférieure à 5 angström RMS sur un champ de 5 micromètres x 5 micromètres. Un nettoyage chimique est appliqué à la couche 1 et au substrat intermédiaire 5 de silicium. Le substrat intermédiaire 5 et la couche 1 sont à cet effet plongés pendant 10 minutes dans une solution d'eau ozonée (Eau désionisée comprenant 20 ppm d'ozone dissout) à 21°C. Ce premier nettoyage chimique assure que les particules isolées, notamment les particules d'hydrocarbures présentes en surface, sont retirées. Le substrat intermédiaire 5 et la couche 1 sont ensuite rincés par de l'eau désionisée. Puis ils sont plongés pendant 10 minutes dans une solution d'APM à 45°C (connue sous l'abréviation anglo-saxonne 'Ammoniac hydrogen Peroxyd Mixture') qui comprend par exemple un mélange d'eau désionisée, d'ammoniaque (30%) et d'eau oxygénée (30%) dans des proportions 5:1:1 respectivement. Ce deuxième nettoyage permet de finaliser le nettoyage des particules de la surface du silicium. La solution, comportant de l'ammoniaque, est riche en ions OH⁻. Ces ions vont alors réagir avec les liaisons pendantes générées en surface du silicium pour former des terminaisons silanols Si-OH qui provoquent l'hydrophilisation de la surface et favorise le collage direct hydrophile. Le substrat intermédiaire 5 et la couche 1 sont ensuite rincés par de l'eau désionisée et sont séchés. Le substrat intermédiaire 5 de silicium recouvert d'une couche d'oxyde 7 propre et ayant des terminaisons Si-OH est alors mis en contact avec la face avant 8 de la couche 1 de silicium recouverte d'une couche oxyde natif 2 pour un collage hydrophile direct tel qu'illustré à la figure 1D.

Un traitement thermique ou recuit de collage est ensuite effectué à 200°C pendant 2 heures afin de renforcer l'énergie de collage intermédiaire Ei. Ce traitement thermique favorise en effet la formation de liaisons hydrogènes entre les terminaisons Si-OH et des liaisons covalentes Si-O-Si à l'interface entre la couche 1 et le substrat intermédiaire 5.

Selon une autre possibilité de réalisation de l'invention non illustrée, le substrat intermédiaire 5 de silicium recouvert d'une couche d'oxyde natif 6 et d'une couche d'oxyde de silicium 7 déposé est collé par collage anodique sur la face avant 8 de la couche 1 de silicium, de sorte à former des liaisons siloxanes Si-O-Si. Le collage anodique est notamment obtenu par la mise en contact des surfaces à coller 7,8, un traitement thermique à environ 400°C et une différence de potentiel entre la couche 1 et le substrat intermédiaire 5 de l'ordre de plusieurs centaines de volts.

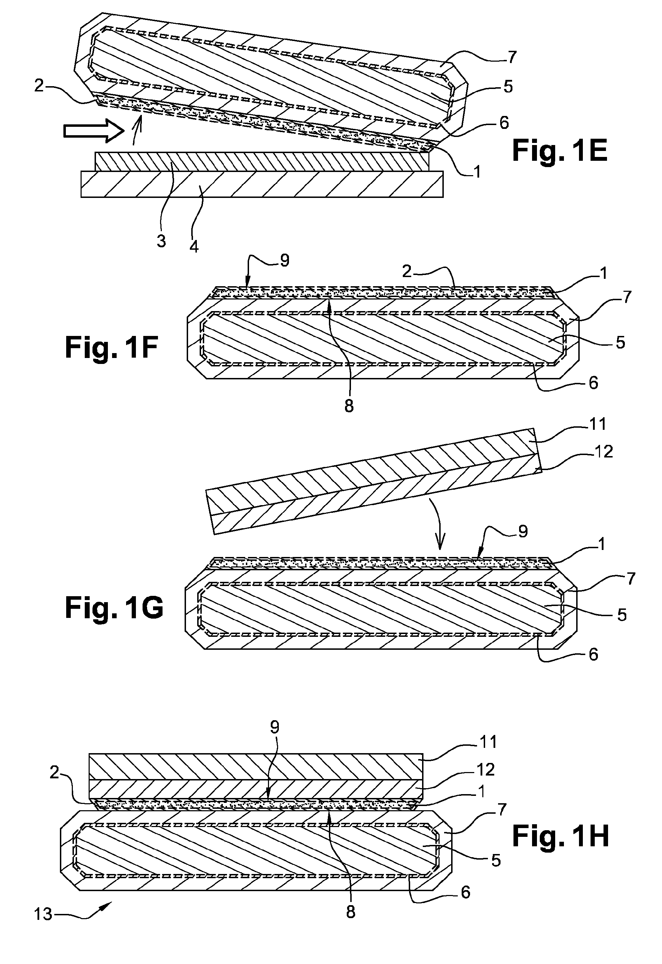

En référence à la figure 1E, la structure constituée de la couche 1 collée au substrat intermédiaire 5 est placée sous atmosphère anhydre de sorte que les liaisons siloxanes Si-O-Si ne soient pas affaiblies par des interactions avec des molécules d'eau. Dans un tel environnement, l'énergie de collage intermédiaire Ei prend la valeur Ei1 d'environ 2,5 J/m² qui est supérieure à l'énergie de liaison E0 d'environ 2 J/m² entre la couche 1 et le substrat initial 4 dont la liaison sera préférentiellement rompue. Une contrainte mécanique illustrée par la flèche représentée à la figure 1E est alors appliquée à l'interface entre la couche 1 et le substrat initial 4 de sorte à faciliter le détachement du substrat initial 4.

En référence à la figure 1F, on obtient un substrat intermédiaire 5 de silicium collé à la face avant 8 d'une couche 1 de silicium de sorte que la face arrière 9 de la couche 1 est exposée. Il est alors possible d'effectuer une ou plusieurs étapes technologiques sur la face arrière 9 de la couche 1, qui est mécaniquement rigidifiée du fait de son collage avec le substrat intermédiaire 5. Cette fonctionnalisation de la face arrière 9 de la couche 1 aurait été impossible à réaliser en présence d'un substrat intermédiaire 5 de polymère qui ne résiste pas aux températures élevées et aux traitements trop agressifs. De préférence, les étapes technologiques ne mettent pas en oeuvre une température supérieure à celle utilisée pour le recuit du collage de sorte à ne pas augmenter l'énergie de collage Ei en créant d'autres liaisons covalentes de siloxane, sauf si le budget thermique appliqué permet in fine de respecter Ei2<Ef.

En référence à la figure 1G, un film 12 de DVS-bis-BCB est formé puis réticulé à la surface d'un substrat final 11 de polyimide tel que le Kapton®. Le film 12 de DVS-BIS-BCB est mis en contact avec la face arrière 9 de la couche 1 fonctionnalisée afin d'obtenir le même type de collage que celui de la couche 1 sur le substrat initial 4. L'énergie de collage final Ef est alors similaire à l'énergie de liaison E0, à savoir environ 2J/m² dans ce mode de réalisation.

La structure intermédiaire 13 alors obtenue est illustrée à la figure 1H. La structure intermédiaire 13 comprend un substrat final 11 de polymère collé à la face arrière 9 d'une couche 1 de silicium par l'intermédiaire d'un film adhésif 12 de DVS-BIS-BCB avec une énergie Ef, et la face avant 8 de la couche 1 est collée à un substrat intermédiaire 5 de silicium avec une énergie Ei.

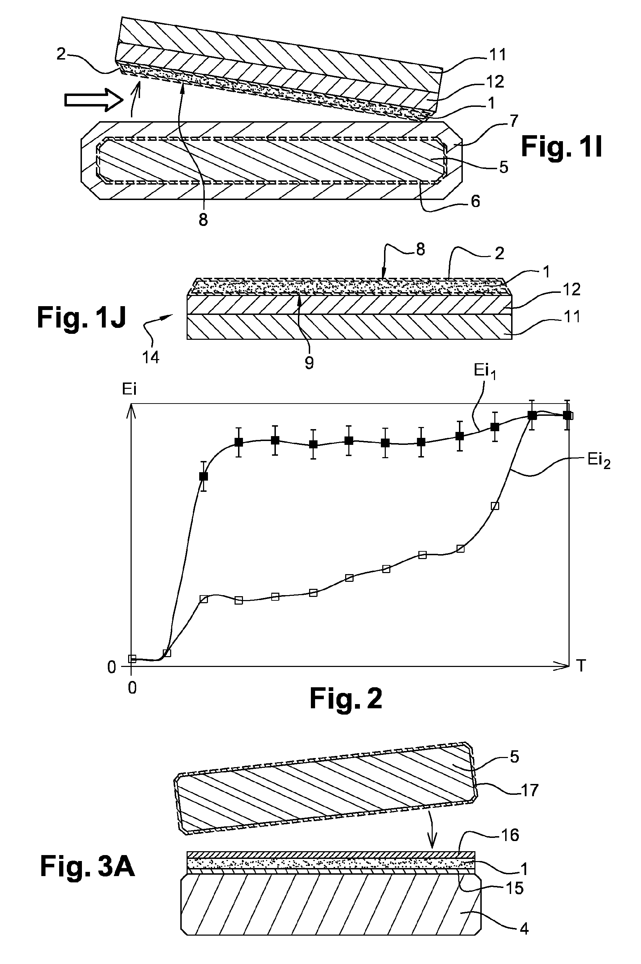

En référence à la figure 1I, la structure intermédiaire 13 est placée sous l'atmosphère humide d'une salle blanche comprenant environ 40% d'humidité. Sous la contrainte mécanique, les liaisons covalentes Si-O-Si sont affaiblies par formation d'interactions avec les molécules d'eau. La liaison siloxane est corrodée et tend à former des terminaisons silanol Si-OH au niveau des surfaces en contact. L'énergie de collage intermédiaire Ei prend alors la valeur Ei2 d'environ 1J/m², inférieure à la valeur de l'énergie de collage final Ef d'environ 2J/m² dans ce mode de réalisation. Une lame est ensuite appliquée au niveau du collage d'énergie Ei2 la plus faible. Le mécanisme de corrosion de la liaison Si-O-Si vient compléter le mécanisme mécanique de décollement au fur et à mesure de l'avancée de lame entre la couche 1 de silicium et le substrat intermédiaire 5.

En référence à la figure 1J, le substrat intermédiaire 5 a été décollé de la face avant 8 de la couche 1. Une structure finale 14 comportant une couche 1 de silicium, dont la face arrière 9 est collée à un substrat final 11 de polyimide par l'intermédiaire d'un film 12 de DVS-BIS-BCB, est alors obtenue.

La figure 2 représente un graphe illustrant la variation de l'énergie Ei obtenue expérimentalement à partir d'un collage direct hydrophile entre une couche 1 de silicium recouverte d'une couche oxyde natif 2 et un substrat intermédiaire 5 de silicium recouvert d'une couche d'oxyde thermique 7. Les deux courbes représentent respectivement la variation de l'énergie du collage sous atmosphère anhydre (triangle - Ei1) et sous atmosphère humide (carré - Ei2) en fonction de la température appliquée. Il en ressort qu'en dessous d'une température seuil, l'énergie de collage est faible pour les deux énergies Ei1 et Ei2. En effet, dans cette plage de température, la couche 1 est principalement collée au substrat intermédiaire 5 par des interactions de type Van Der Waals. Au-delà de cette température seuil, les énergies de collage Ei1 et Ei2 augmentent avec une forte pente. Cette augmentation peut être attribuée à la création de liaisons covalentes, notamment de type Si-O-Si, entre les deux surfaces collées. Cependant, on constate que la pente de variation de l'énergie Ei1 est nettement plus importante que celle de la variation de l'énergie Ei2. Il est notamment possible d'obtenir un rapport entre l'énergie Ei1 et l'énergie Ei2 d'une valeur proche de 4. Ce graphe montre par ailleurs que le procédé de l'invention peut avantageusement s'appliquer sur une large plage de températures pour laquelle l'énergie du collage Ei1 est nettement supérieure à l'énergie Ei2.

Un deuxième mode de réalisation du procédé selon l'invention est maintenant décrit en référence aux figures 3A à 3E où l'énergie de liaison initiale E0 est dans ce cas une énergie de tenue d'une couche poreuse 15. Conformément à la figure 3A une structure comportant une couche poreuse 15 de silicium est initialement obtenue par porosification d'une couche surfacique d'un substrat de silicium. La porosification est par exemple mise en oeuvre par le procédé Eltran. Une couche 1 de silicium monocristallin est ensuite déposée par épitaxie sur la couche poreuse 15. La couche poreuse 15, d'une épaisseur par exemple de 0.5 micromètre et d'une porosité de 80%, est la couche qui permet la tenue entre la couche 1 de silicium et le substrat initial 4 de silicium. Une telle couche poreuse 15 présente une énergie de liaison E0 d'environ 2 J/m². Une couche oxyde thermique 16 est ensuite formée sur la face avant 8 de la couche 1 de silicium par un traitement thermique en milieu humide. Si nécessaire, la couche 1 est planarisée par CMP jusqu'à atteindre une rugosité de moins de 5 angström RMS sur un champ de 5 micromètres x 5 micromètres. Un substrat intermédiaire 5 de silicium présentant une couche d'oxyde de silicium natif 17 est préparé avant la mise en contact avec la face avant 8 de la couche 1. Cette préparation, également effectuée sur la face avant 8 de la couche 1, comprend des étapes de nettoyage avec une solution de SPM à 130°C (connue sous l'abréviation anglo-saxonne de 'Sulfuric acid and hydrogen Peroxide Mixture') comprenant par exemple un mélange d'acide sulfurique (98%) et d'eau oxygénée (30%) dans des proportions de 3 volumes d'acide pour 1 volume d'eau oxygénée, puis une solution d'APM telle que décrite précédemment. Les surfaces ainsi propres et hydrophiles sont mises en contact pour un collage direct hydrophile. Un recuit de stabilisation de ce collage est effectué à 200°C pendant 2 heures.

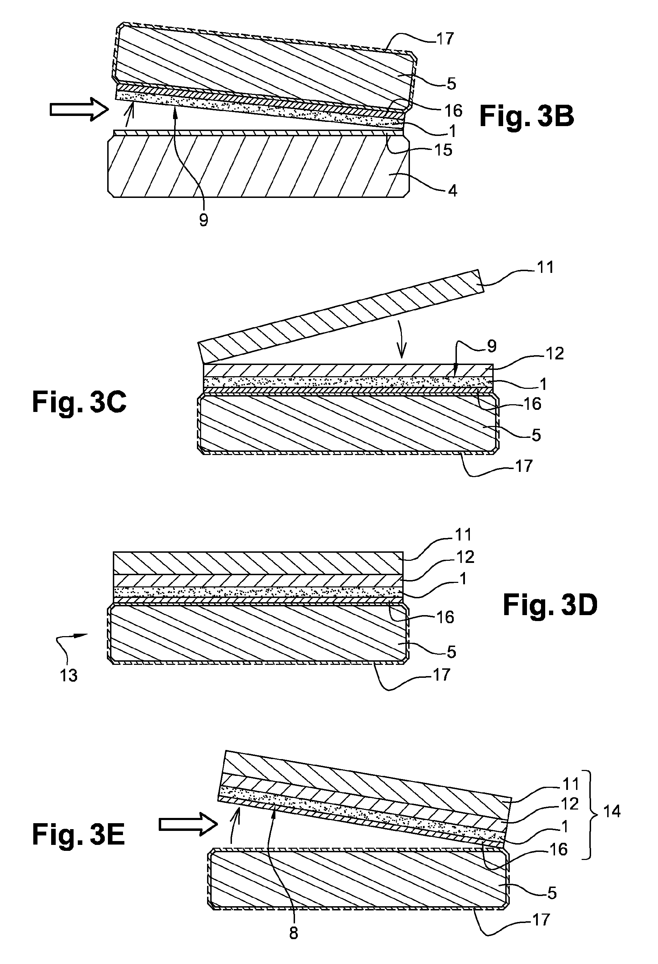

En référence à la figure 3B, la structure ainsi obtenue est placée sous azote sec qui permet d'obtenir une atmosphère anhydre, comprenant moins d'1 ppm de vapeur d'eau. Le collage hydrophile présente alors une énergie de collage intermédiaire Ei1 d'une valeur d'environ 2,5 J/m² bien supérieure à l'énergie de liaison E0 de la couche 15 de silicium poreux de ce mode de réalisation. Ensuite, l'application de mâchoires, symbolisées par la flèche représentée sur la figure 3B, permet le détachement au niveau de l'interface d'énergie la plus faible, entre la couche 1 et le substrat initial 4.

En référence à la figure 3C, la face arrière 9 de la couche 1 transférée sur le substrat intermédiaire 5 est exposée de sorte que des étapes technologiques telles que une CMP, gravures ioniques et/ou dépôt de couches et/ou photolithographie peuvent y être effectuée. Il est entendu que, comme pour le procédé précédemment décrit, ces étapes technologiques ne doivent pas dépasser le budget thermique (température et durée) qui pourrait renforcer le collage intermédiaire et conduire à l'inégalité Ef<Ei2. Un substrat final 11 de polymère de type polyimide est ensuite collé à la face arrière 9 de la couche 1 par l'intermédiaire d'un film 12 de DVS-BIS-BCB réticulé selon le même mode de réalisation que celui précédemment décrit en référence aux figures 1A à 1J.

En référence à la figure 3D, une structure intermédiaire 13 possédant une énergie de collage final Ef, d'une valeur similaire à l'énergie de liaison initiale E0 d'environ 2J/m², est alors obtenue.

Comme illustré à la figure 3E, la structure intermédiaire 13 est placée dans une atmosphère humide, comportant typiquement le taux d'humidité d'une salle blanche (environ 40%). Les liaisons covalentes siloxanes Si-O-Si, à l'origine de la forte énergie de collage entre la couche 1 et le substrat intermédiaire 5, tendent à se rompre lors de l'application d'une contrainte mécanique d'arrachement (ou traction) en présence d'eau pour former des terminaisons silanol Si-OH, produisant un collage par liaison hydrogène, d'une énergie plus faible. L'énergie de collage intermédiaire prend la valeur Ei2 d'environ 1 J/m². Cette technique permet de favoriser sélectivement le décollement de la couche 1 au niveau de l'interface de collage présentant l'énergie la plus faible Ei2. La présence d'eau au niveau du point de séparation accentue la corrosion des liaisons siloxanes qui se rompent pour former des terminaisons silanol diminuant l'énergie de collage en même temps que la contrainte mécanique progresse à l'interface de collage. Une fois le substrat intermédiaire 5 séparé de la structure finale 14, il est nettoyé pour être recyclé dans un autre procédé.

Il est ainsi possible d'obtenir une structure finale 14 comportant un substrat final 11 de polymère sur lequel est collée la face arrière 9 fonctionnalisée d'une couche 1 de silicium par un procédé de double report de couche sélectif et simple à mettre en place. Cette structure finale 14, de même que celle obtenue par le premier mode de réalisation décrit précédemment, peut être utilisée pour des applications dans les domaines des technologies souples, de l'électronique flexible telle que les cartes à puce, les textiles intelligents, de l'électronique, des MEMS, des NEMS, de l'électronique de forte puissance, RF et micro-onde, la microélectronique, l'optique, l'optoélectronique et le photovoltaïque. La couche 1 reportée et/ou la ou les couche(s) éventuellement déposée(s) à sa surface, peuvent avantageusement être utilisées en tant que couche(s) active(s) dans des dispositifs de ces domaines. Par exemple, lorsque le substrat final 11 est suffisamment souple il est possible de réaliser des jauges de contrainte.

De plus, ce procédé permet également l'utilisation de deux types de liaison différents entre la couche 1 et le substrat initial 4 (couche poreuse 15) et entre la couche 1 et le substrat final 11 (collage par adhésif).

Il est par ailleurs possible d'utiliser le procédé de l'invention avec une énergie Ef supérieure à l'énergie de liaison E0 dans la mesure où l'énergie Ef reste inférieure à l'énergie de collage intermédiaire Ei1. Ceci peut être obtenu par exemple selon le premier mode de réalisation décrit ci-avant en référence aux figures 1A à 1J à la différence que la réticulation du film 12 de DVS-BIS-BCB sur le substrat final 11 est mise en oeuvre après la mise en contact de la couche 1 et du substrat final 11. Le traitement de thermo-compression pour coller la couche 1 avec le substrat final 11 peut en effet servir à réticuler le film 12 de DVS-BIS-BCB. Le collage ainsi obtenu permet une plus grande adhérence entre les surfaces, de sorte que l'énergie de collage Ef est plus importante que l'énergie E0.

En outre, la présente invention n'est pas limitée à une couche 1 et des substrats 4,5 ou 11 présentant la forme d'une plaquette d'un diamètre déterminé. L'invention concerne également tout autre type de forme de couche 1 et de substrats 4,5 ou 11, notamment une couche 1 ou des substrats 4,5 ou 11 parallélépipédiques et pouvant être constitués de plusieurs couches.

Ainsi, la présente invention apporte une amélioration déterminante à l'état de la technique antérieure en proposant un procédé de transfert d'une couche 1 simple à mettre en oeuvre, qui permet le recyclage des substrats 4,5, l'application d'étapes technologiques sur la face arrière 9 de la couche 1 et la fabrication d'une structure finale 14 comportant une couche 1 reportée sur un substrat avec une grande variété de types de collage.

Il va de soi que l'invention n'est pas limitée aux modes de réalisation décrits ci-dessus à titre d'exemples mais qu'elle comprend tous les équivalents techniques et les variantes des moyens décrits ainsi que leurs combinaisons.

## Revendications

1. Procédé de transfert d'une couche (1), notamment composée d'un matériau semi-conducteur, isolant ou métallique, le procédé comprenant les étapes de :
a) fourniture d'une couche (1) solidaire d'un substrat initial (4) avec une énergie de liaison E0 entre la couche (1) et le substrat initial (4);
b) collage d'une face avant (8) de la couche (1) sur un substrat intermédiaire (5) selon une énergie de collage intermédiaire Ei;
c) détachement du substrat initial (4) de la couche (1) pour exposer une face arrière (9) de la couche (1);
e) collage d'une face arrière (9) sur un substrat final (11) selon une énergie de collage final Ef; et
f) décollement du substrat intermédiaire (5) de la couche (1) pour transférer la couche (1) sur le substrat final (11);
l'étape b) comprenant une étape de formation de liaisons siloxanes Si-O-Si, l'étape c) étant réalisée sous une première atmosphère anhydre et l'étape f) étant réalisée sous une deuxième atmosphère humide de sorte que l'énergie de collage intermédiaire Ei prend une première valeur Ei1 à l'étape c) et une deuxième valeur Ei2 à l'étape f), avec Ei1 > E0 et Ei2 < Ef et avec Ei1 > Ei2.

2. Procédé de transfert d'une couche (1) selon la revendication 1, **caractérisé en ce que** l'étape b) comprend une étape de mise en oeuvre d'un collage direct hydrophile.

3. Procédé de transfert d'une couche (1) selon la revendication 1, **caractérisé en ce que** l'étape b) comprend une étape de mise en oeuvre d'un collage anodique.

4. Procédé de transfert d'une couche (1) selon l'une des revendications 1 à 3, **caractérisé en ce que** le procédé comprend une étape de formation d'une couche de silicium ou d'une couche d'oxyde choisi parmi le Si02 natif, le SiO2 thermique, le Si02 déposé, le SiOx et le SixOyNz, respectivement sur la face avant (8) de la couche (1) et sur le substrat intermédiaire (5) et **en ce que** l'étape b) comprend une étape de mise en contact des couches formées de sorte à obtenir la formation de liaisons siloxanes Si-O-Si.

5. Procédé de transfert d'une couche (1) selon l'une des revendications 1 à 4, **caractérisé en ce que** la première atmosphère anhydre présente une teneur en vapeur d'eau inférieure à 1 ppm.

6. Procédé de transfert d'une couche (1) selon l'une des revendications 1 à 5, **caractérisé en ce que** la deuxième atmosphère humide présente une teneur en humidité comprise entre 20% et 80%.

7. Procédé de transfert d'une couche (1) selon l'une des revendications 1 à 6, **caractérisé en ce que** le détachement de l'étape c) et/ou le décollement de l'étape f) comprend l'application concomitante d'une contrainte mécanique, telle que l'utilisation de mâchoires, l'application d'une lame ou d'un coin respectivement entre la couche (1) et le substrat initial (4), et entre le substrat intermédiaire (5) et la couche (1).

8. Procédé de transfert d'une couche (1) selon l'une des revendications 1 à 7, **caractérisé en ce qu'**il comprend une étape technologique d), qui est réalisée entre les étapes c) et e), et qui est appliquée à la face arrière (9) de la couche (1), le budget thermique de l'étape technologique présentant une valeur inférieure à une valeur seuil au-delà de laquelle Ei2 > Ef.

9. Procédé de transfert d'une couche (1) selon l'une des revendications 1 à 8, **caractérisé en ce que** l'étape e) comprend une étape de collage mise en oeuvre par l'intermédiaire d'un film adhésif (3), tel qu'un film de divinylsiloxane-bis-benzocyclobutène (DVS-bis-BCB), de polyimide ou de polymère photosensible.

10. Procédé de transfert d'une couche (1) selon l'une des revendications 1 à 8, **caractérisé en ce que** l'étape e) comprend une étape de collage par adhésion moléculaire telle que l'énergie de collage final possède une valeur Ef indépendante du taux d'humidité de la deuxième atmosphère.

11. Procédé de transfert d'une couche (1) selon l'une des revendications 1 à 10, **caractérisé en ce que** l'énergie de liaison E0 entre la couche (1) et le substrat initial (4) est obtenue par formation d'une couche poreuse (15) sur laquelle la couche (1) est déposée.

12. Procédé de transfert d'une couche (1) selon l'une des revendications 1 à 11, **caractérisé en ce que** la couche (1) comprend un matériau de silicium monocristallin et le substrat intermédiaire (5) comprend un matériau de silicium.

13. Procédé de transfert d'une couche (1) selon l'une des revendications 1 à 11, **caractérisé en ce que** la couche (1) comprend un matériau choisi parmi un matériau composé de silicium et de germanium, un matériau d'éléments du groupe II-VI et un matériau binaire, ternaire ou quaternaire d'éléments du groupe III-V.

14. Procédé de transfert d'une couche (1) selon l'une des revendications 1 à 13, **caractérisé en ce que** le matériau du substrat initial (4) et le matériau du substrat final (11) comprennent un matériau choisi parmi le saphir, le silicium, le germanium, la silice, un verre, un quartz, un matériau d'éléments du groupe II-VI, un matériau binaire, ternaire ou quaternaire d'éléments du groupe III-V tel que l'AsGa, l'InP ou le GaN, un métal, un alliage métallique et un polymère, par exemple un polyimide tel que le Kapton®.

15. Structure intermédiaire (13) formée d'un empilement comprenant
- un substrat final (11) en polymère,
- un film adhésif (3) à base de divinylsiloxane-bis-benzocyclobutène (DVS-bis-BCB),
- une couche (1) en silicium monocristallin, et
- un substrat intermédiaire (5) de silicium collé à une face avant (8) de la couche (1) par des liaisons siloxanes Si-O-Si.

16. Structure intermédiaire (13) selon la revendication 15, **caractérisée en ce que** l'énergie de collage final Ef entre une face arrière (9) de la couche (1) et le substrat final (11) est supérieure à l'énergie de collage intermédiaire Ei2 entre la face avant (8) de la couche (1) et le substrat intermédiaire (5) sous une atmosphère présentant une teneur en humidité comprise entre 20 et 80%.

17. Structure finale (14) comprenant un
- substrat final (11) en polymère
- un film adhésif (3) à base de divinylsiloxane-bis-benzocyclobutène (DVS-bis-BCB), et
- une couche (1) en silicium monocristallin,
la face arrière (9) de la couche (1) présentant des fonctionnalités en vue d'applications dans le domaine des technologies souples, de l'électronique flexible telle que les cartes à puce, les textiles intelligents, de l'électronique, des MEMS, des NEMS, de l'électronique de forte puissance, RF et micro-onde, la microélectronique, l'optique, l'optoélectronique et le photovoltaïque.

## Patentansprüche

1. Verfahren zur Übertragung einer Schicht (1), die insbesondere aus einem Halbleitermaterial, Isolierstoff oder metallischen Werkstoff besteht, wobei das Verfahren die folgenden Schritte umfasst:
a) Bereitstellen einer Schicht (1), die mit einem Anfangssubstrat (4) fest verbunden ist und zwar mit einer Bindungsenergie E0 zwischen der Schicht (1) und dem Anfangssubstrat (4);
b) Bonden einer vorderen Fläche (8) der Schicht (1) an ein Zwischensubstrat (5), gemäß einer Zwischenbondenergie Ei;
c) Ablösen des Anfangssubstrats (4) von der Schicht (1), um eine hintere Fläche (9) der Schicht (1) freizulegen;
e) Bonden einer hinteren Fläche (9) an ein Endsubstrat (11), gemäß einer Endbondenergie Ef; und
f) Abheben der Schicht (1) vom Zwischensubstrat (5), um die Schicht (1) auf das Endsubstrat (11) zu übertragen;
wobei der Schritt b) einen Schritt der Bildung von Siloxanbindungen Si-O-Si umfasst, der Schritt c) in einer ersten, wasserfreien Atmosphäre ausgeführt wird und der Schritt f) in einer zweiten, feuchten Atmosphäre ausgeführt wird, derart, dass die Zwischenbondenergie Ei im Schritt c) einen ersten Wert Ei1 annimmt und im Schritt f) einen zweiten Wert Ei2 annimmt, wobei Ei1 > E0 und Ei2 < Ef und wobei Ei1 > Ei2.

2. Verfahren zur Übertragung einer Schicht (1) nach Anspruch 1, **dadurch gekennzeichnet, dass** der Schritt b) einen Schritt der Ausführung eines hydrophilen Direktbondens umfasst.

3. Verfahren zur Übertragung einer Schicht (1) nach Anspruch 1, **dadurch gekennzeichnet, dass** der Schritt b) einen Schritt der Ausführung eines anodischen Bondens umfasst.

4. Verfahren zur Übertragung einer Schicht (1) nach einem der Ansprüche 1 bis 3, **dadurch gekennzeichnet, dass** das Verfahren einen Schritt der Bildung einer Siliciumschicht oder einer Oxidschicht, ausgewählt aus nativem SiO₂, thermischem SiO₂, abgeschiedenem SiO₂, SiOₓ und SiₓO_{y}N_{z}, jeweils an der vorderen Fläche (8) der Schicht (1) und am Zwischensubstrat (5) umfasst und dass der Schritt b) einen Schritt des Inkontaktbringens der gebildeten Schichten umfasst, um die Bildung von Siloxanbindungen Si-O-Si zu erzielen.

5. Verfahren zur Übertragung einer Schicht (1) nach einem der Ansprüche 1 bis 4, **dadurch gekennzeichnet, dass** die erste, wasserfreie Atmosphäre einen Wasserdampfgehalt von weniger als 1 ppm aufweist.

6. Verfahren zur Übertragung einer Schicht (1) nach einem der Ansprüche 1 bis 5, **dadurch gekennzeichnet, dass** die zweite, feuchte Atmosphäre einen Feuchtigkeitsgehalt zwischen 20 % und 80 % aufweist.

7. Verfahren zur Übertragung einer Schicht (1) nach einem der Ansprüche 1 bis 6, **dadurch gekennzeichnet, dass** das Ablösen im Schritt c) und/oder das Abheben im Schritt f) die gleichzeitige Anwendung einer mechanischen Beanspruchung, wie etwa die Verwendung von Klemmbacken, die Anwendung einer Klinge bzw. eines Keils zwischen der Schicht (1) und dem Anfangssubstrat (4) sowie zwischen dem Zwischensubstrat (5) und der Schicht (1) umfasst.

8. Verfahren zur Übertragung einer Schicht (1) nach einem der Ansprüche 1 bis 7, **dadurch gekennzeichnet, dass** es einen Verfahrensschritt d) umfasst, der zwischen den Schritten c) und e) ausgeführt wird und der auf die hintere Fläche (9) der Schicht (1) angewendet wird, wobei der Wärmehaushalt des Verfahrensschritts einen Wert aufweist, der niedriger als ein Schwellenwert ist, jenseits dessen Ei2 > Ef ist.

9. Verfahren zur Übertragung einer Schicht (1) nach einem der Ansprüche 1 bis 8, **dadurch gekennzeichnet, dass** der Schritt e) einen Bondschritt umfasst, der mittels eines Klebstofffilms (3) verwirklicht wird, wie etwa eines Films aus Divinylsiloxan-bis-benzocyclobuten (DVS-bis-BCB), Polyimid oder photosensitivem Polymer.

10. Verfahren zur Übertragung einer Schicht (1) nach einem der Ansprüche 1 bis 8, **dadurch gekennzeichnet, dass** der Schritt e) einen Schritt des Bondens durch Molekularadhäsion umfasst, derart, dass die Endbondenergie einen Wert Ef aufweist, der vom Feuchtigkeitsgehalt der zweiten Atmosphäre unabhängig ist.

11. Verfahren zur Übertragung einer Schicht (1) nach einem der Ansprüche 1 bis 10, **dadurch gekennzeichnet, dass** die Bindungsenergie E0 zwischen der Schicht (1) und dem Anfangssubstrat (4) durch Bilden einer porösen Schicht (15) erhalten wird, auf welcher die Schicht (1) abgeschieden wird.

12. Verfahren zur Übertragung einer Schicht (1) nach einem der Ansprüche 1 bis 11, **dadurch gekennzeichnet, dass** die Schicht (1) ein monokristallines Siliciummaterial umfasst und das Zwischensubstrat (5) ein Siliciummaterial umfasst.

13. Verfahren zur Übertragung einer Schicht (1) nach einem der Ansprüche 1 bis 11, **dadurch gekennzeichnet, dass** die Schicht (1) ein Material umfasst, das ausgewählt ist aus einem Material, das aus Silicium und Germanium besteht, einem Material aus Elementen der II. bis VI. Gruppe und einem binären, ternären oder quaternären Material aus Elementen der III. bis V. Gruppe.

14. Verfahren zur Übertragung einer Schicht (1) nach einem der Ansprüche 1 bis 13, **dadurch gekennzeichnet, dass** das Material des Anfangssubstrats (4) und das Material des Endsubstrats (11) ein Material umfassen, das ausgewählt ist aus Saphir, Silicium, Germanium, Kieselgut, Glas, Quarz, einem Material aus Elementen der II. bis VI. Gruppe, einem binären, ternären oder quaternären Material aus Elementen der III. bis V. Gruppe, wie etwa AsGa, InP oder GaN, Metall, Metalllegierung und Polymer, beispielsweise ein Polyimid wie etwa Kapton®.

15. Zwischenstruktur (13), gebildet aus einem Stapel, der Folgendes umfasst:
- ein Endsubstrat (11) aus Polymer,
- einen Klebstofffilm (3) auf Basis von Divinylsiloxan-bis-benzocyclobuten (DVS-bis-BCB),
- eine Schicht (1) aus monokristallinem Silicium und
- ein Silicium-Zwischensubstrat (5), das über Siloxanbindungen Si-O-Si an eine vordere Fläche (8) der Schicht (1) gebondet ist.

16. Zwischenstruktur (13) nach Anspruch 15, **dadurch gekennzeichnet, dass** die Endbondenergie Ef zwischen einer hinteren Fläche (9) der Schicht (1) und dem Endsubstrat (11) größer als die Zwischenbondenergie Ei2 zwischen der vorderen Fläche (8) der Schicht (1) und dem Zwischensubstrat (5) in einer Atmosphäre ist, die einen Feuchtigkeitsgehalt zwischen 20 und 80 % aufweist.

17. Endstruktur (14), die Folgendes umfasst:
- ein Endsubstrat (11) aus Polymer,
- einen Klebstofffilm (3) auf Basis von Divinylsiloxan-bis-benzocyclobuten (DVS-bis-BCB) und
- eine Schicht (1) aus monokristallinem Silicium,
wobei die hintere Fläche (9) der Schicht (1) Funktionalitäten für Anwendungen im Bereich flexible Technologien, flexible Elektronik wie etwa Chipkarten, intelligente Textilien, Elektronik, MEMS, NEMS, Hochleistungs-, RF- und Mikrowellenelektronik, Mikroelektronik, Optik, Optoelektronik und Photovoltaik aufweist.

## Claims

1. A method for transferring a layer (1), particularly composed of a semiconductor, insulating or metal material, the method comprising the steps of:
a) providing a layer (1) secured to an initial substrate (4) with a binding energy E0 between the layer (1) and the initial substrate (4);
b) bonding a front face (8) of the layer (1) on an intermediate substrate (5) according to an intermediate bonding energy Ei;
c) detaching the initial substrate (4) from the layer (1) to expose a rear face (9) of the layer (1);
e) bonding a rear face (9) to a final substrate (11) according to a final bonding energy Ef; and
f) detaching the intermediate substrate (5) from the layer (1) for transferring the layer (1) onto the final substrate (11);
the step b) comprising a step of forming siloxane bonds Si-O-Si, the step c) being carried out under a first anhydrous atmosphere and the step f) being carried out under a second humid atmosphere so that the intermediate bonding energy Ei takes a first value Ei1 at step c) and a second value Ei2 at step f), with Ei1 > E0 and Ei2 < Ef and with Ei1 > Ei2.

2. The method for transferring a layer (1) according to claim 1, **characterized in that** the step b) comprises a step of implementing a hydrophilic direct bonding.

3. The method for transferring a layer (1) according to claim 1, **characterized in that** the step b) comprises a step of implementing an anodic bonding.

4. The method for transferring a layer (1) according to any of claims 1 to 3, **characterized in that** the method comprises a step of forming a silicon layer or an oxide layer selected from native SiO₂, thermal SiO₂, deposited SiO₂, SiOₓ and SiₓOyN_{z}, respectively on the front face (8) of the layer (1) and on the intermediate substrate (5) and **in that** the step b) comprises a step of contacting layers formed so as to obtain the formation of siloxane bonds Si-O-Si.

5. The method for transferring a layer (1) according to any of claims 1 to 4, **characterized in that** the first anhydrous atmosphere presents water vapor content less than 1 ppm.

6. The method for transferring a layer (1) according to any of claims 1 to 5, **characterized in that** the second humid atmosphere presents moisture content comprised between 20% and 80%.

7. The method for transferring a layer (1) according to any of claims 1 to 6, **characterized in that** the detachment of the step c) and/or the detachment of the step f) comprise(s) the concomitant application of a mechanical stress, such as the use of jaws, the application of a blade or of a wedge respectively between the layer (1) and the initial substrate (4), and between the intermediate substrate (5) and the layer (1).

8. The method for transferring a layer (1) according to any of claims 1 to 7, **characterized in that** it comprises a technological step d), which is carried out between steps c) and e), and which is applied to the rear face (9) of the layer (1), the thermal budget of the technological step presenting a value lower than a threshold value beyond which Ei2 > Ef.

9. The method for transferring a layer (1) according to any of claims 1 to 8, **characterized in that** the step e) comprises a bonding step implemented by means of an adhesive film (3), such as a film of divinylsiloxane-bis-benzocyclobutene (DVS-bis-BCB), of polyimide or of photosensitive polymer.

10. The method for transferring a layer (1) according to any of claims 1 to 8, **characterized in that** the step e) comprises a step of bonding by molecular adhesion such that the final bonding energy has a value Ef independent of the moisture content of the second atmosphere.

11. The method for transferring a layer (1) according to any of claims 1 to 10, **characterized in that** the binding energy E0 between the layer (1) and the initial substrate (4) is obtained by forming a porous layer (15) on which the layer (1) is deposited.

12. The method for transferring a layer (1) according to any of claims 1 to 11, **characterized in that** the layer (1) comprises a monocrystalline silicon material and the intermediate substrate (5) comprises a silicon material.

13. The method for transferring a layer (1) according to any of claims 1 to 11, **characterized in that** the layer (1) comprises a material selected from a material composed of silicon and germanium, a material of elements of the II-VI group and a binary, ternary or quaternary material of elements of the III-V group.

14. The method for transferring a layer (1) according to any of claims 1 to 13, **characterized in that** the material of the initial substrate (4) and the material of the final substrate (11) comprise a material selected from sapphire, silicon, germanium, silica, glass, quartz, a material of elements of the II-VI group, a binary, ternary or quaternary material of elements of the III-V group such as AsGa, InP or GaN, a metal, a metal alloy and a polymer, for example a polyimide such as Kapton®.

15. An intermediate structure (13) formed of a stack comprising
- a final substrate (11) made of polymer,
- an adhesive film (3) based on divinylsiloxane-bis-benzocyclobutene (DVS-bis-BCB),
- a layer (1) made of monocrystalline silicon, and
- an intermediate silicon substrate (5) bonded to a front face (8) of the layer (1) by siloxane bonds Si-O-Si.

16. The intermediate structure (13) according to claim 15, **characterized in that** the final bonding energy Ef between a rear face (9) of the layer (1) and the final substrate (11) is greater than the intermediate bonding energy Ei2 between the front face (8) of the layer (1) and the intermediate substrate (5) under an atmosphere presenting a moisture content comprised between 20 and 80%.

17. A final structure (14) comprising a
- final substrate (11) made of polymer
- an adhesive film (3) based on divinylsiloxane-bis-benzocyclobutene (DVS-bis-BCB), and
- a layer (1) made of monocrystalline silicon,
the rear face (9) of the layer (1) presenting functionalities for applications in the field of flexible technologies, flexible electronics such as smart cards, smart textiles, electronics, micro-electromechanical systems MEMS, nano-electromechanical systems NEMS, high power electronics, RF and microwave, microelectronics, optics, optoelectronics and photovoltaics.
